(19) Europäisches Patentamt
European Patent Office
Office européen des brevets

(11) Veröffentlichungsnummer: **0 035 713**
**B1**

(12) # EUROPÄISCHE PATENTSCHRIFT

(45) Veröffentlichungstag der Patentschrift: **23.11.83**

(51) Int. Cl.³: **H 01 B 1/12**

(21) Anmeldenummer: **81101421.6**

(22) Anmeldetag: **27.02.81**

(54) **Verfahren zur Herstellung elektrisch leitfähiger Heteropolyphenylene und deren Verwendung in der Elektrotechnik und zur antistatischen Ausrüstung von Kunststoffen.**

(30) Priorität: **12.03.80 DE 3009351**

(43) Veröffentlichungstag der Anmeldung: **16.09.81 Patentblatt 81/37**

(45) Bekanntmachung des Hinweises auf die Patenterteilung: **23.11.83 Patentblatt 83/47**

(84) Benannte Vertragsstaaten: **AT BE CH DE FR GB LI NL**

(56) Entgegenhaltungen:
**EP - A - 0 016 305**
**EP - A - 0 023 596**
**EP - A - 0 031 444**
**DE - B - 1 178 529**

**JOURNAL OF THE CHEMICAL SOCIETY, CHEM. COMM. Nr. 8, 6. Mai 1980, Seiten 348-349 R.R. CHANCE et al.: "Highly conducting charge-transfer complexes of a processible polymer: poly(p-phenylene sulphide)"**

(73) Patentinhaber: **BASF Aktiengesellschaft, Carl-Bosch-Strasse 38, D-6700 Ludwigshafen (DE)**

(72) Erfinder: **Blinne, Gerd, Dr., Im Woogtal 7, D-6719 Bobenheim (DE)**
Erfinder: **Naarmann, Herbert, Dr., Haardtblick 15, D-6719 Wattenheim (DE)**
Erfinder: **Penzien, Klaus, Dr., Bensheimer Ring 18, D-6710 Frankenthal (DE)**

**EP 0 035 713 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

Für die Vertragsstaaten CH, DE, FR, GB, LI, NL

# Verfahren zur Herstellung elektrisch leitfähiger Heteropolyphenylene und deren Verwendung in der Elektrotechnik und zur antistatischen Ausrüstung von Kunststoffen

Die Erfindung betrifft ein Verfahren zur Herstellung von elektrisch leitfähigen Heteropolyphenylenen mit elektrischen Leitfähigkeitswerten grösser als $10^{-2}$ S/cm und deren Verwendung in der Elektroindustrie zur Herstellung von Sonnenzellen, zur Umwandlung und Fixierung von Strahlung und zur Herstellung elektrischer und magnetischer Schalter sowie zur antistatischen Ausrüstung von Kunststoffen.

Es ist bereits bekannt, Polyphenylene durch oxidative Kupplung entsprechend der Literatur: „Macromolecular Syntheses Collective", vol. 1 (1977), S. 109 und 110, und „Naturwissenschaften" *56* (1969), S. 308 bis 313, herzustellen. Ausserdem ist die Herstellung von Polyphenylenen durch stufenweise Polykondensation nach R. Gehm und W. Kern aus „Makromolekulare Chemie" *7* (1951), S. 46 bis 61, bekannt, wobei besonders einheitliche paraverkettete methylsubstituierte Derivate erhalten werden, die nicht zusätzlich durch ortho- oder metaverknüpfte Polymere verunreinigt sind. Die Heteropolyphenylene unterscheiden sich hiervon durch das Vorhandensein von Heteroatomen oder Heteroatome enthaltenden Gruppen zwischen den aromatischen Ringsystemen. Solche Produkte sind z.B. beschrieben in „Macromolecular Syntheses", vol. 6 (1978), 45-48.

Der Erfindung lag die Aufgabe zugrunde, Heteropolyphenylene durch Zusätze in elektrisch leitfähige Produkte mit elektrischen Leitfähigkeitswerten grösser als $10^{-2}$ S/cm umzuwandeln.

Gemäss einer Ausführungsform der Erfindung wird diese Aufgabe gelöst durch ein Verfahren zur Herstellung von elektrisch leitfähigen Heteropolyphenylenen mit elektrischen Leitfähigkeiten grösser als $10^{-2}$ S/cm, bei dem Heteropolyphenylenen der allgemeinen Formel Ia:

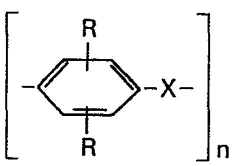 (Ia)

worin X = S, O, NH, Se, $SO_2$ oder

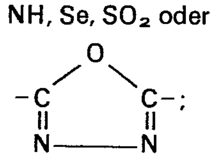

R = H, $Ch_3$, Phenyl oder Cyclohexyl, und n = 2 bis 200, insbesondere 3 bis 50, bedeuten, unter Ausschluss von Wasserfeuchtigkeit und von Sauerstoff 0,5 bis 35 Gew.-%, bezogen auf das eingesetzte Heteropolyphenylen, einer starken Lewis-Säure mit einem $pK_s$-Wert von $-10$ bis $+4$ zugesetzt werden, welches dadurch gekennzeichnet ist, dass als Lewis-Säure $UF_6$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-Trinitrophenol, 2,4,6-Trinitrophenylsulfonsäure oder 2,4,6-Trinitrobenzoesäure zugesetzt wird.

Bevorzugt sind hierbei unter anderem Heteropolyphenylene mit einer S- oder O-Verknüpfung der Phenylringe in para-Stellung.

Gemäss einer weiteren Ausführungsform betrifft die Erfindung ein Verfahren zur Herstellung von elektrisch leitfähigen Heteropolyphenylenen mit elektrischen Leitfähigkeiten grösser als $10^{-2}$ S/cm, bei dem Heteropolyphenylenen unter Auschluss von Wasserfeuchtigkeit und von Sauerstoff 0,5 bis 35 Gew.-%, bezogen auf das eingesetzte Heteropolyphenylen, einer starken Lewis-Säure mit einem $pK_s$-Wert von $-10$ bis $+4$ zugesetzt werden, welches dadurch gekennzeichnet ist, dass Heteropolyphenylene der allgemeinen Formel Ib:

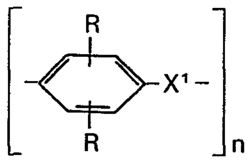 (Ib)

eingesetzt werden, worin bedeuten $X^1$ = NH oder

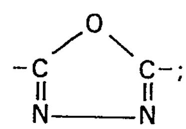

R = H, $CH_3$, Phenyl oder Cyclohexyl, und n = 2 bis 200, bevorzugt 3 bis 50.

Im letztgenannten Fall, in dem Heteropolyphenylene der Formel Ib mit der NH- oder 1,3,4-Oxadiazolgruppe als Heteroatom enthaltenden Gruppe eingesetzt werden, können als aktivierende Zusatzstoffe für die Steigerung der elektrischen Leitfähigkeit beliebige Lewis-Säuren mit $pK_s$-Werten von $-10$ bis $+4$ eingesetzt werden. Neben den weiter oben genannten Verbindungen kommen hierbei als Lewis-Säuren insbesondere auch $AsF_5$, $SbF_5$ oder $HClO_4$ in Betracht.

Die erfindungsgemäss einzusetzenden Heteropolyphenylene Ia und Ib weisen ein Molekulargewicht von 800 bis 500 000, vorzugsweise zwischen 10 000 und 100 000, auf. Die Herstellung der Heteropolyphenylene kann nach der eingangs zitierten Literatur erfolgen.

Die elektrischen Leitfähigkeitswerte werden in Siemens pro Zentimeter (S/cm) bei 30°C gemessen, die Messung selbst erfolgt nach der Methode von F. Beck, „Berichte Bunsengesellschaft, Physikalische Chemie" *68* (1964), S. 558 bis 567. Die elektrischen Leitfähigkeitswerte der erfindungsgemäss hergestellten, elektrisch leitfähigen Heteropolyphenylene sind grösser als $10^{-2}$ S/cm.

Nach dem erfindungsgemässen Verfahren werden den Heteropolyphenylenen unter Ausschluss von Wasserfeuchtigkeit und von Sauerstoff 0,5 bis 35 Gew.-%, bezogen auf das eingesetzte Heteropolyphenylen, einer starken Lewis-Säure mit einem $pK_s$-Wert von −10 bis +4 zugesetzt. Es wird daher vorzugsweise unter Edelgas(Argon)atmosphäre gearbeitet. Gegebenenfalls werden Hilfsflüssigkeiten wie Tetrahydrofuran, Dimethoxyglykol, Nitromethan oder Methylenchlorid eingesetzt, die nach dem Einarbeiten der Lewis-Säuren bei Temperaturen unter 30°C im Vakuum abgezogen werden.

Durch die Zusätze der Lewis-Säuren können elektrische Leitfähigkeitsanstiege von einigen Grössenordnungen erreicht werden. Die Ausgangsleitfähigkeiten der nach der oxidativen Kupplungsmethode hergestellten Heteropolyphenylene liegen im allgemeinen nicht über $10^{-12}$ S/cm. Nach der Zugabe der Lewis-Säuren werden jedoch Leitfähigkeiten grösser als $10^{-2}$ S/cm erzielt.

Die erfindungsgemäss hergestellten, elektrisch leitfähigen Heteropolyphenylene mit elektrischen Leitfähigkeiten grösser als $10^{-2}$ S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter geeignet. Durch die Zusätze der starken Lewis-Säuren zu den Heteropolyphenylenen entstehen sog. para-Leiter (vgl. „J. Chem. Education", vol. *46*, Nr. 2, S. 82 [1969]).

Die in den folgenden Beispielen genannten Teile sind, sofern nicht anders angegeben, Gewichtsteile. Die Bestimmung des Molgewichts erfolgt z.B. über die Intrinsic-Viskosität (η) dl/g in $CHCl_3$ bei 25°C (Lit. „Macromolecular Syntheses Coll.", vol. 1 S. 81 [1977]).

*Beispiele 1 bis 4:*

10 Teile eines Heteropolyphenylens werden unter Argonatmosphäre und Ausschluss von Feuchtigkeit mit der jeweiligen Lewis-Säure (Zusatzstoff) versetzt. Die Messung der elektrischen Leitfähigkeit erfolgt nach F. Beck, „Ber. Bunsengesellschaft, Phys. Chem." *68*, S. 558 bis 567, 1964. Die näheren Angaben sowie die erzielten Ergebnisse sind der nachfolgenden Tabelle zu entnehmen.

| Beispiel Nr. | Heteropolyphenylen 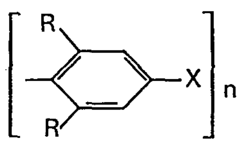 Typ und Menge | | | Zusatzstoff Art und Menge (Mol.-%) | Leitfähigkeit S/cm 30°C | |
|---|---|---|---|---|---|---|
| | R | X | Molgewicht | | vor dem Zusatz | nach dem Zusatz |
| 1 | 10 Teile, H,H | NH | 15000 | 2,4,6-Trinitrophenylsulfonsäure 0,2 | $<10^{-13}$ | $1{,}8\cdot10^{-2}$ |
| 2 | 10 Teile, H,H | Se | 16000 | 2,4,6-Trinitrophenylsulfonsäure 0,2 | $<10^{-13}$ | $6{,}9\cdot10^{-1}$ |
| 3 | 10 Teile, $CH_3$,$CH_3$ | O | 29000 | $NO^+SbF_6^-$ 0,3 | $<10^{-13}$ | $4{,}7\cdot10^{-1}$ |
| 4 | 10 Teile, H,H | 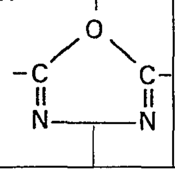 | 18000 | $NO^+PF_6^-$ 0,3 | $\sim10^{-12}$ | $3{,}5\cdot10^{-1}$ |

Für die Vertragsstaaten AT, BE

Verfahren zur Herstellung elektrisch leitfähiger Heteropolyphenylene und deren Verwendung in der Elektrotechnik und zur antistatischen Ausrüstung von Kunststoffen

Die Erfindung betrifft ein Verfahren zur Herstellung von elektrisch leitfähigen Heteropolyphenylenen mit elektrischen Leitfähigkeitswerten grösser als $10^{-2}$ S/cm und deren Verwendung in der Elektroindustrie zur Herstellung von Sonnenzellen, zur Umwandlung und Fixierung von Strahlung und zur Herstellung elektrischer und magnetischer Schalter sowie zur antistatischen Ausrüstung von Kunststoffen.

Es ist bereits bekannt, Polyphenylene durch oxidative Kupplung entsprechend der Literatur: „Macromolecular Syntheses Collective", vol. 1 (1977), S. 109 und 110, und „Naturwissenschaften" *56* (1969), S. 308 bis 313, herzustellen. Ausserdem ist die Herstellung von Polyphenylenen durch stufenweise Polykondensation nach R. Gehm und W. Kern aus „Makromolekulare Chemie" *7* (1951), S. 46 bis 61, bekannt, wobei besonders einheitliche paraverkettete methylsubstituierte Derivate erhalten werden, die nicht

zusätzlich durch ortho- oder metaverknüpfte Polymere verunreinigt sind. Die Heteropolyphenylene unterscheiden sich jedoch durch das vorhandensein von Heteroatomen oder Heteroatome enthaltende Gruppen zwischen den aromatischen Ringsystemen. Diese erfindungsgemässen Produkte sind z.B. beschrieben in „Macromolecular Syntheses", vol. 6 (1978), 45-48.

Der Erfindung lag die Aufgabe zugrunde, die an sich bekannten Heteropolyphenylene durch Zusätze in elektrisch leitfähige Polymere mit elektrischen Leitfähigkeitswerten grösser als $10^{-2}$ S/cm umzuwandeln.

Diese Aufgabe wird erfindungsgemäss dadurch gelöst, dass man den Heteropolyphenylenen unter Ausschluss von Wasserfeuchtigkeit und von Sauerstoff 0,5 bis 35 Gew.-%, bezogen auf das eingesetzte Heteropolyphenylen, eine starke Lewis-Säure mit $pK_s$-Werten von −10 bis +4 zusetzt. Nach bevorzugter Verfahrensweise wird als Lewis-Säure die Verbindung $AsF_5$, $SbF_5$, $UF_6$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-Trinitrophenol, 2,4,6-Trinitrophenylsulfonsäure oder 2,4,6-Trinitrobenzoesäure zugesetzt.

Unter Heteropolyphenylenen werden höhermolekulare Produkte verstanden, deren Ketten bestehen aus aneinander gekoppelten, gegebenenfalls Substituierten R tragenden Phenylringen gemäss der allgemeinen Formel:

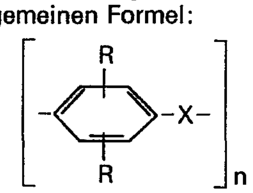

wobei X bedeutet: S, O, NH, Se, $SO_2$,

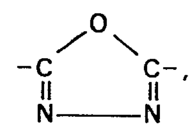

und R = H, $CH_3$ oder Phenyl, Cyclohexyl, n = 2 bis 200, bevorzugt 3 bis 50.

Bevorzugt sind Heteropolyphenylene mit einer S- oder O-Verknüpfung der Phenylringe in para-Stellung. Die Heteropolyphenylene weisen ein Molekulargewicht von 800 bis 500 000, vorzugsweise zwischen 10 000 und 100 000, auf. Die Herstellung der Heteropolyphenylene kann nach der eingangs zitierten Literatur erfolgen.

Die elektrischen Leitfähigkeitswerte werden in Siemens pro Zentimeter (S/cm) bei 30°C gemessen, die Messung selbst erfolgt nach der Methode von F. Beck, „Berichte Bunsengesellschaft, Physikalische Chemie" *68* (1964), S. 558 bis 567. Die elektrischen Leitfähigkeitswerte der erfindungsgemässen leitfähigen Heteropolyphenylene ist grösser als $10^{-2}$ S/cm.

Nach dem erfindungsgemässen Verfahren wird den Heteropolyphenylenen unter Ausschluss von Wasserfeuchtigkeit und von Sauerstoff 0,5 bis 35 Gew.-%, bezogen auf das eingesetzte Polyphenylen, eine starke Lewis-Säure mit $pK_s$-Werten von −10 bis +4 zugesetzt.

Das Einarbeiten der Zusätze erfolgt unter Ausschluss von Feuchtigkeit (Wasser) sowie Sauerstoff (Luft), es wird daher vorzugsweise unter Edelgas(Argon)atmosphäre gearbeitet. Gegebenenfalls werden Hilfsflüssigkeiten wie Tetrahydrofuran, Dimethoxyglykol, Nitromethan oder Methylenchlorid eingesetzt, die nach dem Einarbeiten bei Temperaturen unter 30°C im Vakuum abgezogen werden.

Durch die genannten Zusätze können elektrische Leitfähigkeitsanstiege von einigen Grössenordnungen erreicht werden. Die Ausgangsleitfähigkeiten der nach der oxydativen Kupplungsmethode hergestellten Heteropolyphenyle betrugen $10^{-12}$ S/cm, liefern aber nach der Zugabe der erfindungsgemässen Zusätze Leitfähigkeiten grösser als $10^{-2}$ S/cm.

Die erfindungsgemäss hergestellten, elektrisch leitfähigen Heteropolyphenylene mit elektrischen Leitfähigkeiten grösser als $10^{-2}$ S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter geeignet. Durch die Zusätze der starken Lewis-Säure mit Heteropolyphenylen entstehen sog. para-Leiter (vgl. „J. Chem. Education", vol. *46*, Nr. 2, S. 82 [1969]).

Die in den folgenden Beispielen genannten Teile sind Gewichtsteile bzw. Molprozente. Die Angabe der Gliederzahl n (Kettenlänge der Polyphenylene) erfolgt durch Endgruppenanalyse über IR-Bestimmung des Verhältnisses der monofunktionellen Endgruppe

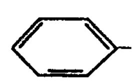 zur difunktionellen Mittelgruppe 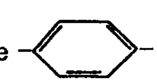.

Die Bestimmung des Molgewichts erfolgt z.B. über die Intrinsic-Viskosität (η) dl/g $CHCl_3$ bei 25°C (Lit. „Macromolecular Syntheses Coll.", vol. 1, S. 81 [1977]).

*Beispiele 1 bis 8:*

10 Teile eines Heteropolyphenylens werden unter Argonatmosphäre und Ausschluss von Feuchtigkeit mit dem jeweiligen Zusatzstoff versetzt, die Messung der elektrischen Leitfähigkeit erfolgt nach F. Beck, „Ber. Bunsengesellschaft, Phys. Chem." *68*, 558-567, 1964.

*(Tabelle auf der nächsten Seite)*

**Patentansprüche für die Vertragsstaaten** CH, DE, FR, GB, LI, NL

1. Verfahren zur Herstellung von elektrisch leitfähigen Heteropolyphenylenen mit elektrischen

| Beispiel Nr. | Polyphenylen 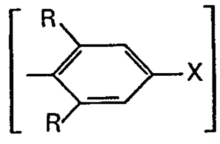 Typ und Menge | | | Zusatzstoff Art und Menge (Mol.-%) | Leitfähigkeit S/cm 30°C | |
|---|---|---|---|---|---|---|
| | R | X | Molgewicht | | vor dem Zusatz | nach dem Zusatz |
| 1 | 10 Teile, H,H | S | 50000 | $AsF_5$ 0,2 | $<10^{-13}$ | $4{,}3\cdot10^{-2}$ |
| 2 | 10 Teile, H,H | S | 26000 | $SbF_5$ 0,18 | $<10^{-13}$ | $2{,}5\cdot10^{-2}$ |
| 3 | 10 Teile, $CH_3$,$CH_3$ | O | 30000 | $HClO_4$ 0,2 | $<10^{-13}$ | $4{,}1\cdot10^{-2}$ |
| 4 | 10 Teile, $C_6H_5$,$C_6H_5$ | O | 22000 | $HClO_4$ 0,2 | $<10^{-13}$ | $3{,}9\cdot10^{-1}$ |
| 5 | 10 Teile, H,H | NH | 15000 | 2,4,6-Trinitrophenylsulfonsäure 0,2 | $<10^{-13}$ | $1{,}8\cdot10^{-2}$ |
| 6 | 10 Teile, H,H | Se | 16000 | 2,4,6-Trinitrophenylsulfonsäure 0,2 | $<10^{-13}$ | $6{,}9\cdot10^{-1}$ |
| 7 | 10 Teile, $CH_3$,$CH_3$ | O | 29000 | $NO^+SbF_6^-$ 0,3 | $<10^{-13}$ | $4{,}7\cdot10^{-1}$ |
| 8 | 10 Teile, H,H | 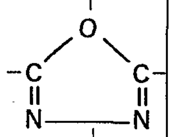 | 18000 | $NO^+PF_6^-$ 0,3 | $\sim10^{-12}$ | $3{,}5\cdot10^{-1}$ |

Leitfähigkeitswerten grösser als $10^{-2}$ S/cm, bei dem Heteropolyphenylenen der allgemeinen Formel (Ia):

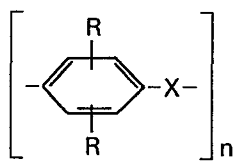 (Ia)

worin X = S, O, NH, Se, $SO_2$ oder

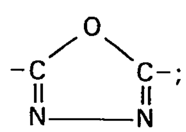

R = H, $CH_3$, Phenyl oder Cyclohexyl, und n = 2 bis 200 bedeuten, unter Ausschluss von Wasserfeuchtigkeit und von Sauerstoff 0,5 bis 35 Gew.-%, bezogen auf das eingesetzte Heteropolyphenylen, einer starken Lewis-Säure mit einem $pK_s$-Wert von −10 bis +4 zugesetzt werden, dadurch gekennzeichnet, dass als Lewis-Säure $UF_6$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-Trinitrophenol, 2,4,6-Trinitrophenylsulfonsäure oder 2,4,6-Trinitrobenzoesäure zugesetzt wird.

2. Verfahren zur Herstellung von elektrisch leitfähigen Heteropolyphenylenen mit elektrischen Leitfähigkeitswerten grösser als $10^{-2}$ S/cm, bei dem Heteropolyphenylenen unter Ausschluss von Wasserfeuchtigkeit und von Sauerstoff 0,5 bis 35 Gew.-%, bezogen auf das eingesetzte Heteropolyphenylen, einer starken Lewis-Säure mit einem $pK_s$-Wert von −10 bis +4 zugesetzt werden, dadurch gekennzeichnet, dass Heteropolyphenylene der allgemeinen Formel (Ib):

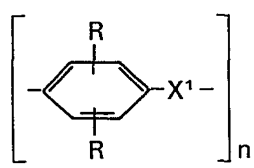 (Ib)

eingesetzt werden, worin bedeuten $X^1$ = NH oder

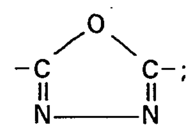

R = H, $CH_3$, Phenyl oder Cyclohexyl, und n = 2 bis 200.

3. Verfahren nach Anspruch 2, dadurch gekennzeichnet, dass als Lewis-Säure $AsF_5$, $SbF_5$, $UF_6$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-Trinitrophenol, 2,4,6-Trinitrophenylsulfonsäure oder 2,4,6-Trinitrobenzoesäure zugesetzt wird.

4. Verwendung der nach einem der beiden Ansprüche 1 oder 2 hergestellten, elektrisch leitfähigen Heteropolyphenylene in der Elektrotechnik zur Herstellung von Sonnenzellen, zur Umwandlung und Fixierung von Strahlung und zur Herstellung elektrischer und magnetischer Schalter.

5. Verwendung der nach einem der beiden Ansprüche 1 oder 2 hergestellten, elektrisch leitfähigen Heteropolyphenylene zur antistatischen Ausrüstung von Kunststoffen.

**Patentansprüche für die Vertragsstaaten** AT, BE

1. Verfahren zur Herstellung von elektrisch leitfähigen Heteropolyphenylenen mit elektrischen Leitfähigkeitswerten grösser als $10^{-2}$ S/cm, dadurch gekennzeichnet, dass den Heteropolyphenylenen unter Ausschluss von Wasserfeuchtigkeit und von Sauerstoff 0,5 bis 35 Gew.-%, bezogen auf das eingesetzte Heteropolyphenylen, einer starken Lewis-Säure mit $pK_s$-Werten von $-10$ bis $+4$ zugesetzt werden.

2. Verfahren nach Anspruch 1, dadurch gekennzeichnet, dass als Lewis-Säure die Verbindung $AsF_5$, $SbF_5$, $UF_6$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-Trinitrophenol, 2,4,6-Trinitrophenylsulfonsäure oder 2,4,6-Trinitrobenzoesäure zugesetzt wird.

3. Verwendung der nach Anspruch 1 hergestellten, leitfähigen Heteropolyphenylene in der Elektrotechnik zur Herstellung von Sonnenzellen, zur Umwandlung und Fixierung von Strahlung und zur Herstellung elektrischer und magnetischer Schalter.

4. Verwendung der nach Anspruch 1 hergestellten, leitfähigen Heteropolyphenylene zur antistatischen Ausrüstung von Kunststoffen.

**Claims for the contracting States** CH, DE, FR, GB, LI, NL

1. A process for the preparation of an electrically conductive hetero-polyphenylene having a conductivity greater then $10^{-2}$ S/cm, by adding to the hetero-polyphenylene of the general formula (Ia):

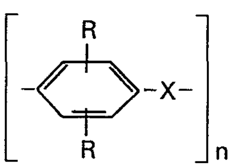

(Ia)

where
X is S, O, NH, Se, $SO_2$ or

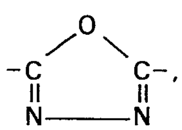

R is H, $CH_3$, phenyl or cyclohexyl,
and n is an integer from 2 to 200,
from 0.5 to 35 per cent by weight, based on the hetero-polyphenylene employed, of a strong Lewis acid having a pKa of from $-10$ to $+4$, in the absence of moisture and of oxygen, wherein the Lewis acid used is $UF_6$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-trinitrophenol, 2,4,6-trinitrophenylsulfonic acid or 2,4,6-trinitrobenzoic acid.

2. A process for the preparation of an electrically conductive hetero-polyphenylene having a conductivity greater than $10^{-2}$ S/cm, by adding to the hetero-polyphenylene from 0.5 to 35 per cent by weight, based on the hetero-polyphenylene employed, of a strong Lewis acid having a pKa of from $-10$ to $+4$, in the absence of moisture and of oxygen, wherein there is used a hetero-polyphenylene of the general formula (Ib):

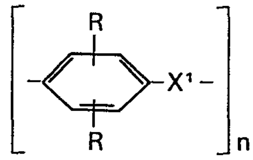

(Ib)

where
$X^1$ is NH or

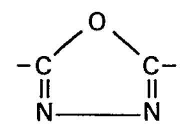

R is H, $CH_3$, phenyl or cyclohexyl,
and n is an integer from 2 to 200.

3. A process as claimed in claim 2, wherein the Lewis acid used is $AsF_5$, $SbF_5$, $UF_6$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-trinitrophenol, 2,4,6-trinitrophenylsulfonic acid or 2,4,6-trinitrobenzoic acid.

4. The use of an electrically conductive hetero-polyphenylene, produced as claimed in claim 1 or 2, in electrical engineering for the production of solar cells, for the conversion and fixing of radiation and for the production of electrical and magnetic switches.

5. The use of an electrically conductive hetero-polyphenylene, produced as claimed in claim 1 or 2, for the antistatic treatment of plastic materials.

**Claims for the contracting States** BE, AT

1. A process for the preparation of an electrically conductive hetero-polyphenylene having a conductivity greater than $10^{-2}$ S/cm, wherein from 0.5 to 35 per cent by weight, based on the hetero-polyphenylene employed, of a strong Lewis acid having a pKa of from $-10$ to $+4$ is added to the hetero-polyphenylene, in the absence of moisture and of oxygen.

2. A process as claimed in claim 1, wherein the Lewis acid used is $AsF_5$, $SbF_5$, $UF_6$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, 2,4,6-trinitrophenol, 2,4,6-trinitrophenylsulfonic acid or 2,4,6-trinitrobenzoic acid.

3. The use of an electrically conductive hetero-polyphenylene, produced as claimed in claim 1, in electrical engineering for the production of solar cells, for the conversion and fixing of radiation and for the production of electrical and magnetic switches.

4. The use of an electrically conductive hetero-polyphenylene, produced as claimed in claim 1, for the antistatic treatment of plastic materials.

**Revendications pour les Etats contractants**
CH, DE, FR, GB, LI, NL

1. Procédé pour la préparation d'hétéropolyphénylènes électriquement conducteurs, ayant des valeurs de conductibilité supérieures à $10^{-2}$ S/cm, consistant à ajouter, en l'absence d'humidité et d'oxygène, à des hétéropolyphénylènes de formule générale (Ia):

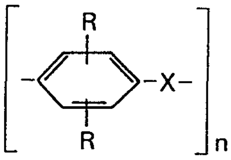
(Ia)

dans laquelle:
X = S, O, NH, Se, $SO_2$ ou

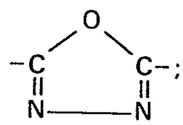

R = H, $CH_3$, phényle ou cyclohexyle,
et n = 2 à 200,
0,5 à 35% en poids, par raport à l'hétéropolyphénylène utilisé, d'un acide de Lewis fort ayant une valeur pKa de −10 à +4, caractérisé en ce qu'on ajoute, en tant qu'acide de Lewis, $UF_6$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, du 2,4,6-trinitrophénol, de l'acide 2,4,6-trinitrophénylsulfonique ou de l'acide 2,4,6-trinitrobenzoïque.

2. Procédé pour la préparation d'hétéropolyphénylènes électriquement conducteurs, ayant des valeurs de conductibilité supérieures à $10^{-2}$ S/cm, consistant à ajouter, en l'absence d'humidité et d'oxygène, aux hétéropolyphénylènes 0,5 à 35% en poids, par rapport à l'hétéropolyphénylène utilisé, d'un acide de Lewis fort ayant une valeur pKa de −10 à +4, caractérisé en ce qu'on utilise des hétéropolyphénylènes de formule générale (Ib):

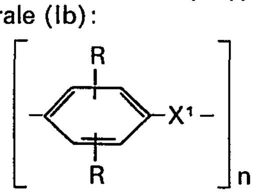
(Ib)

dans laquelle:
$X^1$ = NH ou

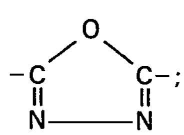

R = H, $CH_3$, phényle ou cyclohexyle,
et n = 2 à 200.

3. Procédé selon la revendication 2, caractérisé en ce qu'on ajoute, en tant qu'acide de Lewis, $AsF_5$, $SbF_5$, $UF_6$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, du 2,4,6-trinitrophénol, de l'acide 2,4,6-trinitrophénylsulfonique ou de l'acide 2,4,6-trinitrobenzoïque.

4. Utilisation des hétéropolyphénylènes électriquement conducteurs, préparés suivant l'une des revendications 1 ou 2, dans l'électrotechnique, pour la fabrication de cellules solaires, pour la transformation et la fixation de radiations et pour la fabrication de commutateurs électriques et magnétiques.

5. Utilisation des hétéropolyphénylènes électriquement conducteurs, préparés suivant l'une des revendications 1 ou 2, pour le traitement antistatique de matières synthétiques.

**Revendications pour les Etats contractants**
BE, AT

1. Procédé de préparation d'hétéropolyphénylènes conducteurs de l'électricité avec une conductibilité électrique supérieure à $10^{-2}$ S/cm, caractérisé en ce que l'on incorpore aux hétéropolyphénylènes, à l'abri de l'humidité et de l'oxygène, entre 0,5 et 35% en poids, par rapport à l'hétéropolyphénylène mis en œuvre, d'un acide de Lewis fort avec un pKa entre −10 et +4.

2. Procédé suivant la revendication 1, caractérisé en ce que l'acide de Lewis incorporé est choisi parmi $AsF_5$, $SbF_5$, $UF_6$, $HClO_4$, $NO^+SbF_6^-$, $NO_2^+SbF_6^-$, $NO^+AsF_6^-$, $NO^+PF_6^-$, $NO_2^+PF_6^-$, $NO^+BF_4^-$, $NO_2^+BF_4^-$, $NO^+ClO_4^-$, $(CF_3)_2SO_4$, le 2,4,6-trinitrophénol, l'acide 2,4,6-trinitrophénylsulfonique et l'acide 2,4,6-trinitrobenzoïque.

3. Utilisation des hétéropolyphénylènes conducteurs de l'électricité, préparés selon la revendication 1, dans le domaine de l'électrotechnique pour la fabrication de cellules solaires, pour la transformation ou la fixation de radiations et pour la fabrication de commutateurs électriques et magnétiques.

4. Utilisation des hétéropolyphénylènes conducteurs de l'électricité, préparés selon la revendication 1, pour l'apprêtage antistatique de matières plastiques.